# EUROPEAN PATENT APPLICATION

(11) **EP 2 355 162 A1**
(43) Date of publication of application: **10.08.2011**
(21) Application number: 09823576.5
(22) Date of filing: 27.10.2009
(51) Int. Cl.: H01L 31/04, C08L 101/02, C09K 11/06

(54) **COMPOSITIONS FOR FORMING WAVELENGTH-CONVERTING MEMBRANES FOR PHOTOVOLTAIC DEVICES, WAVELENGTH-CONVERTING MEMBRANES FOR PHOTOVOLTAIC DEVICES, AND PHOTOVOLTAIC DEVICES**

(30) Priority: 31.10.2008 JP 2008281183; 02.04.2009 JP 2009090392
(71) Applicant: Nissan Chemical Industries, Ltd., Chiyoda-ku Tokyo 101-0054 (JP)
(72) Inventor: IMAMURA, Hikaru, Funabashi-shi Chiba 274-0052 (JP)
(74) Representative: HOFFMANN EITLE
(86) International application number: PCT/JP2009/068396
(87) International publication number: WO 2010/050466

(57) **Abstract**

It is an object to improve photoelectric conversion efficiency by use of a wavelength conversion film that is formed without dispersion of wavelength conversion substance and by using no rare earth compound. There is provided a composition for easily forming such a wavelength conversion film by spin-coating or the like. The present invention relates to a composition for forming a wavelength conversion film for a photovoltaic device, comprising a polymer or an oligomer in which a fluorescent moiety is incorporated, and a solvent. The fluorescent moiety may be incorporated in a main chain or a side chain of the polymer or the oligomer. The present invention also relates to a wavelength conversion film for a photovoltaic device that is formed from the composition for forming a wavelength conversion film.

## Description

### TECHNICAL FIELD

The present invention relates to a composition for forming a wavelength conversion film to be provided in photovoltaic devices such as solar cells, in which conversion efficiency from light energy to electric power is improved. The present invention also relates to a wavelength conversion film that is formed using the composition.

### BACKGROUND ART

Various solar cells such as ones of a pn junction type and ones of a dye-sensitization type have been studied and brought into actual use. However, conventional solar cells in actual use cannot be said to have sufficiently high photoelectric conversion efficiency.

In order to improve conversion efficiency, solar cells having a wavelength conversion function to convert, among incident light wavelengths, a wavelength (one in ultraviolet range, for example) that does not contribute to photoelectric conversion to a wavelength (one in visible light range, for example) that contributes to photoelectric conversion have been considered. Such solar cells are disclosed in, for example, Patent Documents 1 to 10 listed below.

### Related Art Documents

### Patent Documents

Patent Document 1: Japanese Patent Application Publication No. JP-A-7-142752
Patent Document 2: Japanese Patent Application Publication No. JP-A-9-230396
Patent Document 3: Japanese Patent Application Publication No. JP-A-2000-313877
Patent Document 4: Japanese Patent Application Publication No. JP-A-2001-308365
Patent Document 5: Japanese Patent Application Publication No. JP-A-2003-243682
Patent Document 6: Japanese Patent Application Publication No. JP-A-2004-297025
Patent Document 7: Japanese Patent Application Publication No. JP-A-2006-173545
Patent Document 8: Japanese Patent Application Publication No. JP-A-2006-269373
Patent Document 9: Japanese Patent Application Publication No. JP-A-2006-303033
Patent Document 10: Japanese Patent Application Publication No. JP-A-2007-265629

### DISCLOSURE OF THE INVENTION

### Problem to be solved by the Invention

As described in Patent Documents 1 to 10 listed above, the solar cells having a wavelength conversion function that have been previously suggested have a characteristic to have a film in which a wavelength conversion substance, that is to say a fluorescent substance, is dispersed. Patent Document 1 suggests a wavelength conversion layer containing another substance (transparent resin, etc) in which a single or a plurality of wavelength conversion substances are dispersed, as well as a wavelength conversion layer consisting of the wavelength conversion substance. In Examples in Patent Document 1, however, the former, namely, a wavelength conversion layer in which N-methyl-2-anilino-naphthalene-6-sulfonic acid is dispersed in polymethyl methacrylate or a p-type silicon layer, is solely described, and production of a wavelength conversion layer consisting of a wavelength conversion substance is not specifically described.

As for a film having a wavelength conversion function and having a fluorescent substance dispersed therein, in the case of incorporating excessive amounts of the fluorescent substance into the film in order to enhance a wavelength conversion effect, there would be problems that the quality of the film alters due to aggregation of the fluorescent substance or the like, uniform dispersion of the fluorescent substance in the film becomes difficult, and the like. Furthermore, in the case where a rare earth element such as europium (Eu) and terbium (Tb) or a rare earth complex is used as a fluorescent substance, there would also be a problem that because of growing demand for rare earth compounds in recent years and a rise in prices thereof due to uneven distribution of resources, cost reduction is difficult to be achieved.
It is an object of the present invention to obtain a composition for forming a wavelength conversion film for a photovoltaic device that can be expected to improve photoelectric conversion efficiency of wavelength conversion as well as can promote cost reduction. It is another object of the present invention to provide a wavelength conversion film for a photovoltaic device that is formed of the composition, and a photovoltaic device that includes the conversion film.

### Means for Solving the Problem

The present invention provides a composition for forming a wavelength conversion film for a photovoltaic device that contains a polymer or an oligomer having a fluorescent moiety (a fluorescence emitting moiety) and a solvent.

The fluorescent moiety in the polymer or the oligomer contained in the composition for forming a wavelength conversion film according to the present invention is incorporated in a main chain or a side chain of the polymer or the oligomer, and specific examples thereof include anthracene and derivatives thereof, coumarin and derivatives thereof, fluorescein and derivatives thereof, rhodamine, eosin, perylene and derivatives thereof, fluorene and derivatives thereof, and stilbene and derivatives thereof.

Examples of the polymer or the oligomer contained in the composition for forming a wavelength conversion film according to the present invention include acrylic resins, methacrylate resins, novolac resins, aminoplast polymers, polyamides, polyimides, polyesters, polyfluorene, polyfluorene derivatives, polysiloxanes, polysilane, and polycarbosilanes. The number average molecular weight Mn of the polymer or the oligomer is, for example, within the range of 500 to 50,000.

Examples of the solvent contained in the composition for forming a wavelength conversion film according to the present invention include organic solvents such as propylene glycol monomethyl ether acetate (PGMEA), propylene glycol monomethyl ether (PGME), propylene glycol monoethyl ether, ethyl lactate, cyclohexanone, cyclohexanol, γ-butyrolactone, diethylene glycol, propylene glycol, dipropylene glycol, 2,3-butanediol, triethylene glycol, diethylene glycol monoethyl ether acetate, diethylene glycol monobutyl ether acetate, diethylene glycol monoethyl ether, diethylene glycol monoethyl ether, diethylene glycol monobutyl ether, diethylene glycol dibutyl ether, dipropylene glycol monomethyl ether, glycerin, butyl acetate, hexyl acetate, diacetone alcohol, propylene carbonate, tetrahydrofurfuryl alcohol, acetylacetone, toluene, N,N-dimethylformamide, and N-methyl-2-pyrrolidone (NMP). The solvent may be a combination of two or more organic solvents. Regarding components that remain after removing a solvent from the composition for forming a wavelength conversion film according to the present invention as a solid content, the ratio of the solid content in the composition is, for example, 3 to 40% by mass, and preferably, 7 to 30% by mass.

The polymer or the oligomer contained in the composition for forming a wavelength conversion film according to the present invention may further have a crosslinked moiety. Examples of the crosslinked moiety include hydroxy groups, carboxy groups, epoxy groups, amino groups, silanol groups, and alkynyl groups.
The composition for forming a wavelength conversion film according to the present invention may further contain a crosslinking agent. In the case where a crosslinked moiety is provided or a crosslinking agent is incorporated, and where the stability (in particular, heat resistance and light resistance) of the polymer or the oligomer is inadequate, the stability can be improved by crosslinking. Examples of the crosslinking agent include hexamethoxymethylmelamine, tetramethoxymethylbenzoguanamine, 1,3,4,6-tetrakis(methoxymethyl)glycoluril, 1,3,4,6-tetrakis(butoxymethyl)glycoluril, 1,3,4,6-tetrakis(hydroxymethyl)glycoluril, 1,3-bis(hydroxymethyl)urea, 1,1,3,3-tetrakis(butoxymethyl)urea, 1,1,3,3-tetrakis(methoxymethyl)urea, blocked isocyanate (a compound that is 4,4'-diphenylmethane diisocyanate, polymethylene polyphenyl polyisocyanate, tolylene diisocyanate, hexamethylene diisocyanate, isophorone diisocyanate, tetramethyl xylylene diisocyanate, and the like protected by alcohols such as methanol, ethanol, propanol, isopropyl alcohol, butanol, 2-ethylhexanol, and cyclohexanol, phenols, active methylenes such as dimethyl malonate and ethyl acetoacetate, oximes such as methyl ethyl ketone oxime, acetone oxime, cyclohexanone oxime, acetophenone oxime, and benzophenone oxime, and lactams such as ε-caprolactam, γ-caprolactam, and β-propiolactam).

The composition for forming a wavelength conversion film according to the present invention may further contain an antioxidant and/or a radical scavenger as an additive. The antioxidant and the radical scavenger may be known compounds and can improve the stability (in particular, heat resistance and light resistance) of the polymer or the oligomer if the stability is inadequate. Such an additive may or may not be used in combination with a crosslinking agent, and may or may not be used in combination with the polymer or the oligomer having a crosslinked moiety.

The present invention is also directed to a wavelength conversion film for a photovoltaic device that is formed of the composition for forming a wavelength conversion film. The wavelength conversion film according to the present invention can be easily formed by various coating methods such as spin-coating, spraying, and dipping, and can be formed at relatively low temperatures of around 160°C (for example, 100°C to 220°C).
The wavelength conversion film for a photovoltaic device thus obtained can be used in solar cells.
A wavelength conversion film can be obtained by coating a film that is a base material with the composition for forming a wavelength conversion film according to the present invention.
A wavelength conversion film can also be formed by stretching or a similar method using the composition for forming a wavelength conversion film according to the present invention as a raw material.

### Effects of the Invention

Because of containing no rare earth compound, the composition for forming a wavelength conversion film for a photovoltaic device of the present invention makes it possible to provide a wavelength conversion film for a photovoltaic device at low cost, and therefore makes it possible to expect improvement in photoelectric conversion efficiency of a solar cell at low cost.
Furthermore, by forming a film using a polymer or an oligomer to which a fluorescent moiety (a fluorescence emitting moiety) is chemically bonded, a larger amount of fluorescent moieties (fluorescence emitting moieties) can be incorporated into the film than that of fluorescent substance in the case of incorporating the fluorescent substance by using a film in which a wavelength conversion substance (a fluorescent substance) is dispersed, and the stability of the wavelength conversion film to be formed improves. In addition, further improvement in photoelectric conversion efficiency of various solar cells can be expected by selecting a suitable fluorescent moiety.

### BRIEF DESCRIPTION OF THE DRAWINGS

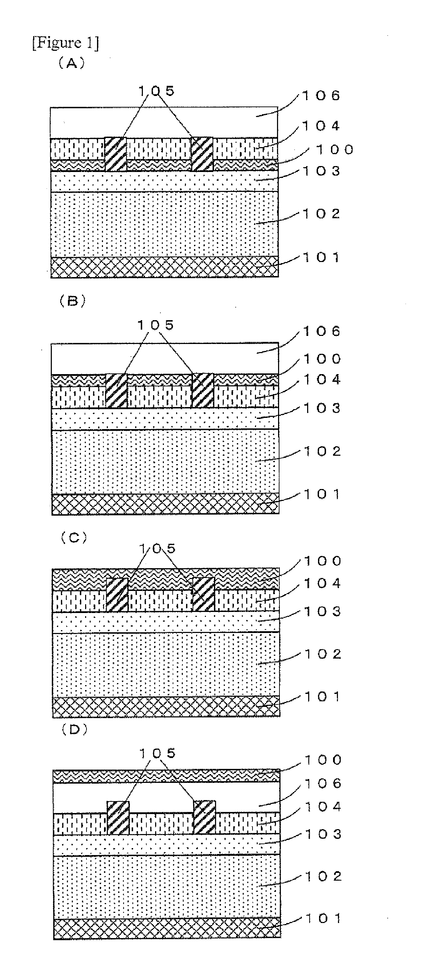

[FIG. 1] FIGS. 1A to 1D each shows an example of applying a wavelength conversion film that is formed of the composition for forming a wavelength conversion film according to the present invention in a silicon solar cell.

### BEST MODES FOR CARRYING OUT THE INVENTION

Examples of the polymer or the oligomer contained in the composition for forming a wavelength conversion film according to the present invention include acrylic resins, methacrylate resins, novolac resins, aminoplast polymers, polyamides, polyimides, and polyesters. The novolac resin may be either phenol novolac or cresol novolac. As the polymer or the oligomer, polyfluorene or a derivative thereof, polysiloxane, polysilane, or polycarbosilane may be used.

Examples of the fluorescent moiety (the fluorescence emitting moiety) in the polymer or the oligomer include anthracene and derivatives thereof (2-anthracenecarboxylic acid, 9-anthracenecarboxylic acid, 2-vinylanthracene, 9-vinylanthracene, 9-hydroxymethylanthracene, and the like), coumarin and derivatives thereof (4-hydroxycoumarin, 7-hydroxycoumarin, and the like), fluorescein and derivatives thereof (fluorescein isothiocyanate and the like), rhodamine (rhodamine B, rhodamine 6G, and the like), eosin (eosin-Y, eosin-B, and the like), perylene and derivatives thereof (3,4,9,10-perylenetetracarboxylic dianhydride and the like), fluorene and derivatives thereof (9-fluorenol, 1-fluorene carboxylic acid, 9-fluorene carboxylic acid, 9,9-bis (4-hydroxyphenyl) fluorene, and the like), and stilbene and derivatives thereof (4,4'-stilbene dicarboxylic acid and the like). The fluorescent moiety (the fluorescence emitting moiety) is, for example, incorporated into a side chain of the polymer or the oligomer, or may be contained in a main chain of the polymer or the oligomer. Incorporation of the fluorescent moiety (the fluorescence emitting moiety) into a side chain of the polymer or the oligomer can be performed by graft polymerization, for example. The incorporation ratio of the fluorescent moiety is not particularly limited and may be any ratio higher than 0 mol% relative to the polymer or the oligomer.

The wavelength conversion film according to the present invention has a function to convert a wavelength that does not contribute to photoelectric conversion to a wavelength that contributes to photoelectric conversion. Specifically, the wavelength conversion film according to the present invention converts a certain wavelength to a longer wavelength, for example, a wavelength shorter than 370 nm to a wavelength of 370 nm or longer. In particular, the wavelength conversion film according to the present invention converts a wavelength in ultraviolet range (10 nm to 365 nm) to a wavelength in visible light range (370 nm to 800 nm). The range of the wavelength that contributes to photoelectric conversion varies depending on the type of solar cell and, for example, the range varies even among silicon solar cells depending on the crystal morphology of the silicon to be used. For example, the range is considered to be about 400 nm to about 700 nm for amorphous silicon solar cells, and about 600 nm to about 1100 nm for polycrystalline silicon solar cells. Therefore, the wavelength that contributes to photoelectric conversion is not necessarily a wavelength in visible light range.

A solar cell to which the wavelength conversion film according to the present invention is applied is not limited to a particular type, and examples thereof include silicon solar cells in which amorphous silicon, polycrystalline silicon, and the like are used, compound semiconductor solar cells in which GaAs, CIS, CIGS, and the like are used, organic solar cells such as organic thin-film solar cells, dye-sensitized solar cells, quantum dot solar cells, and the like. The arrangement of the wavelength conversion film is not particularly limited, and may be any arrangement provided that the wavelength conversion film is provided in a light receiving area of a solar cell.

The present invention will be specifically described. The present invention is not limited to the description of the following Synthesis Examples and Examples.

### Examples

Average molecular weights of polymers shown in the present specification are results from measurement by gel permeation chromatography (hereinafter, abbreviated as GPC). Devices used, conditions, and the like are as follows.

### Synthesis Examples 1 to 6 and 9

GPC device: HLC-8220GPC (manufactured by Tosoh Corporation)
GPC column: Asahipak [registered trademark] GF510HQ (manufactured by Showa Denko K.K.)
Column temperature: 40°C
Solvent: 10 mmol/L lithium bromide monohydrate in dimethylformamide (DMF) solution
Flow rate: 0.6 ml/minute
Standard sample: polystyrene (manufactured by Showa Denko K.K.)
Synthesis Examples 7, 8, and 10
GPC device: HLC-8220GPC (manufactured by Tosoh Corporation)
GPC column: Shodex [registered trademark] KF803L, KF802, and KF801 (manufactured by Showa Denko K.K.)
Column temperature: 40°C
Solvent: tetrahydrofuran (THF)
Flow rate: 1.0 ml/minute
Standard sample: polystyrene (manufactured by Showa Denko K.K.)

Epoxy values shown in the present specification are results from measurement by titration.
Devices used, conditions, and the like are as follows.
Titrator: automatic titrator GT- 100 (manufactured by Mitsubishi Chemical Corporation)
Titration reagent: 0.1 mol/L perchloric acid in acetic acid solution
Solvent: propylene glycol monomethyl ether

### (Synthesis Example 1)

Into a reaction vessel the inside of which is replaced with nitrogen, 40 g of the monomer of Formula (1): 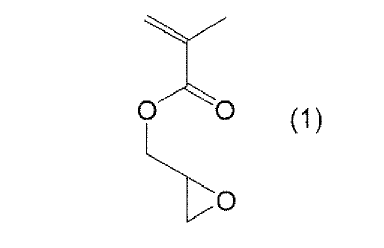 (manufactured by Tokyo Chemical Industry Co., Ltd.) and 128 g of tetrahydrofuran were added, and the mixture was stirred under reflux. A mixed solution of 2 g of α,α'-azobisisobutyronitrile and 40 g of tetrahydrofuran was added dropwise thereto. After 12 hours of stirring, the reaction solution was cooled to room temperature, and was added dropwise to 2,100 g of diethyl ether for reprecipitation. The average molecular weights measured by GPC of the polymer obtained were 19,000 as the weight average molecular weight and 7,800 as the number average molecular weight in terms of standard polystyrene. The epoxy value was 6.9 mol/kg.

### (Synthesis Example 2)

To 3.00 g of the polymer obtained in Synthesis Example 1, 0.46 g of the monomer of Formula (2): 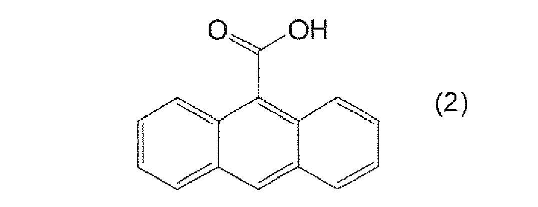 (manufactured by Tokyo Chemical Industry Co., Ltd.) that is an anthracene derivative, 0.11 g of benzyltriethylammonium chloride, and 14.28 g of propylene glycol monomethyl ether were added, and the mixture was stirred for 24 hours under reflux. The reaction solution was cooled to room temperature and was added dropwise to 200 g of diethyl ether for reprecipitation. The epoxy value was 5.6 mol/kg. The polymer obtained is expressed as Formula (1-2) in which the unit structure A and the unit structure B are arranged orderly or randomly in a linear order.

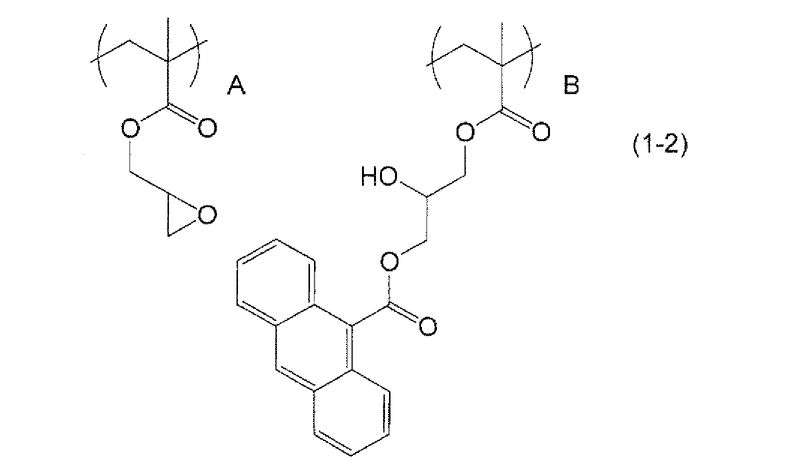

### (Synthesis Example 3)

To 3.00 g of the polymer obtained in Synthesis Example 1, 0.34 g of the monomer of Formula (3): 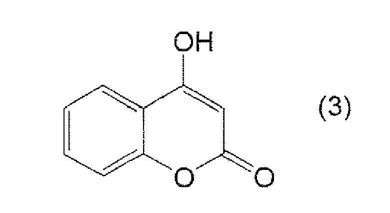 (manufactured by Tokyo Chemical Industry Co., Ltd.) that is a coumarin derivative, 0.11 g of benzyltriethylammonium chloride, and 13.79 g of propylene glycol monomethyl ether were added, and the mixture was stirred for 24 hours under reflux. The reaction solution was cooled to room temperature, and was added dropwise to 200 g of diethyl ether for reprecipitation. The epoxy value was 6.1 mol/kg. The polymer obtained is expressed as Formula (1-3) in which the unit structure A and the unit structure C are arranged orderly or randomly in a linear order.

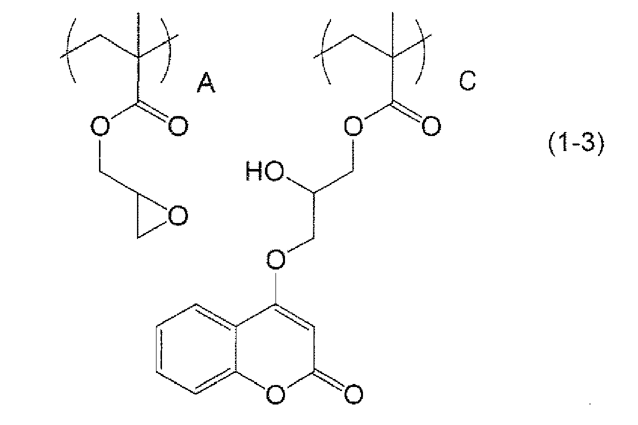

### (Synthesis Example 4)

To 3.00 g of the polymer obtained in Synthesis Example 1, 0.34 g of the monomer of Formula (4): 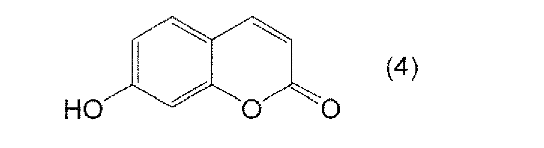 (manufactured by Tokyo Chemical Industry Co., Ltd.) that is a coumarin derivative, 0.11 g of benzyltriethylammonium chloride, and 13.79 g of propylene glycol monomethyl ether were added, and the mixture was stirred for 24 hours under reflux. The reaction solution was cooled to room temperature and was added dropwise to 200 g of diethyl ether for reprecipitation. The epoxy value was 5.6 mol/kg. The polymer obtained is expressed as Formula (1-4) in which the unit structure A and the unit structure D are arranged orderly or randomly in a linear order.

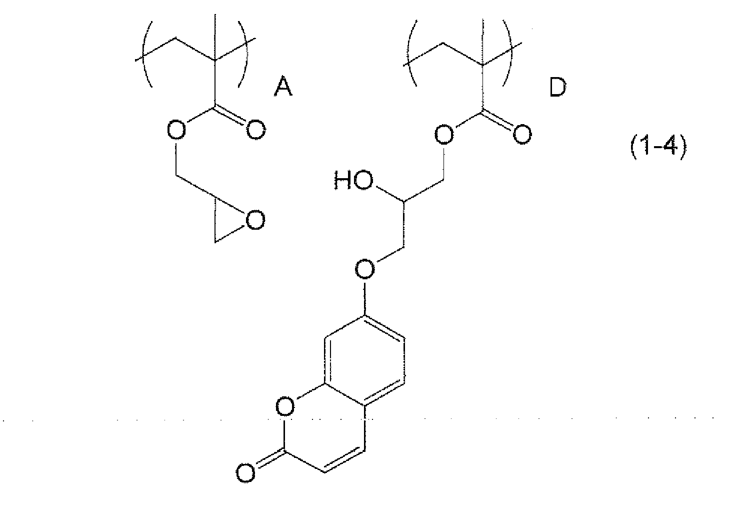

### (Synthesis Example 5)

To 3.00 g of the polymer obtained in Synthesis Example 1, 0.99 g of the monomer of Formula (5): 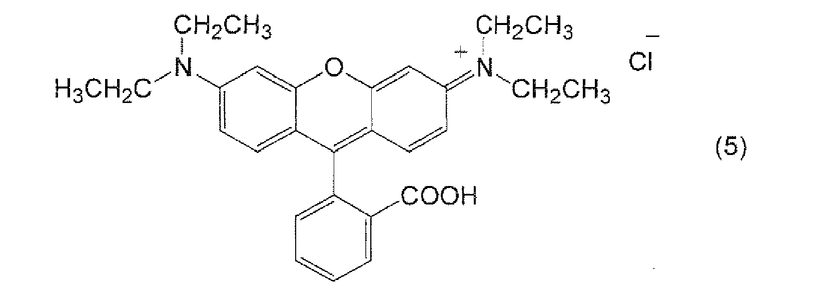 (manufactured by Tokyo Chemical Industry Co., Ltd.) that is a rhodamine, 0.11 g of benzyltriethylammonium chloride, and 16.41 g of propylene glycol monomethyl ether were added, and the mixture was stirred for 24 hours under reflux. The reaction solution was cooled to room temperature and was added dropwise to 200 g of diethyl ether for reprecipitation. The epoxy value was 6.8 mol/kg.

### (Synthesis Example 6)

To 3.00 g of the polymer obtained in Synthesis Example 1, 0.69 g of the monomer of Formula (6): 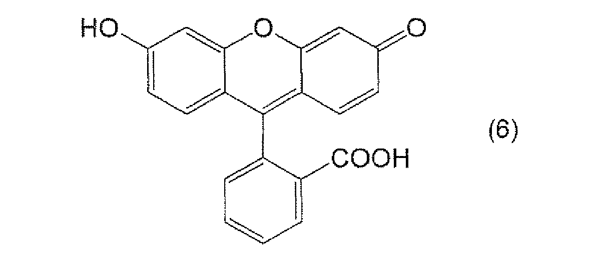 (manufactured by Tokyo Chemical Industry Co., Ltd.) that is fluorescein, 0.11 g of benzyltriethylammonium chloride, and 15.20 g of propylene glycol monomethyl ether were added, and the mixture was stirred for 24 hours under reflux. The reaction solution was cooled to room temperature and was added dropwise to 200 g of diethyl ether for reprecipitation. The epoxy value was 6.7 mol/kg.

### (Synthesis Example 7)

A solution containing the polymer of Formula (7) that is a copolymer having the unit structure E and the unit structure B at a molar ratio of E:B=0.65:0.35 was prepared. The average molecular weight measured by GPC of the polymer was 36,000 as the weight average molecular weight in terms of standard polystyrene. 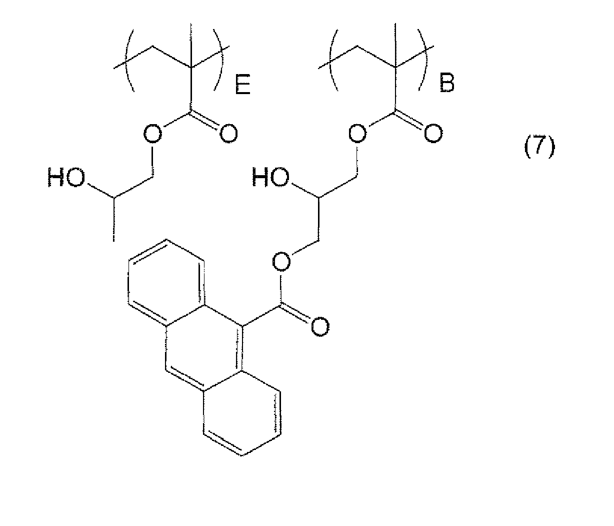 The polymer of Formula (7) is obtained by polymerizing hydroxypropyl methacrylate and glycidyl methacrylate at a molar ratio of 0.65:0.35 using α,α'-azobisisobutyronitrile as a radical initiator and then, to the resultant polymer of Formula below, adding 9-anthracenecarboxylic acid (of Formula (2) above).

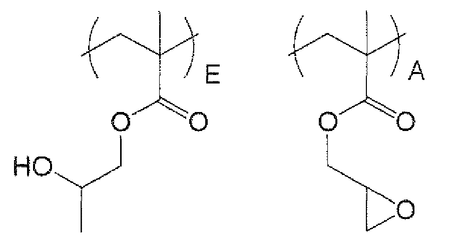

### (Synthesis Example 8)

A solution containing a polymer having the unit structure of Formula (8) was prepared. The average molecular weights measured by GPC of the polymer were 6,100 as the weight average molecular weight and 2,700 as the number average molecular weight in terms of standard polystyrene. 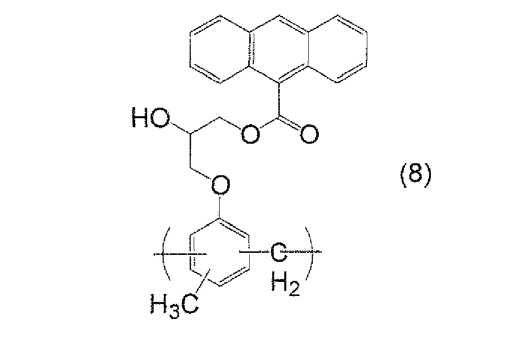 The polymer of Formula (8) is obtained by adding 9-anthracenecarboxylic acid to epoxy cresol novolac.

### (Synthesis Example 9)

A solution containing the polymer obtained according to Example 3 (Formulation I) described in Japanese Translation of PCT International Application No. 2003-531252 using CYMEL [registered trademark] 303 (hexamethoxymethylmelamine) of Formula (9a) and CYMEL [registered trademark] 1123 (tetramethoxymethylbenzoguanamine) of Formula (9b) (both are from Cytec Industries Inc.) was prepared. The polymer is an aminoplast polymer, and the average molecular weights thereof by GPC were 11,000 as the weight average molecular weight and 2,200 as the number average molecular weight in terms of standard polystyrene. In the polymer of this Synthesis Example, a benzoguanamine unit structure derived from Formula (9b) is estimated to be a fluorescent moiety.

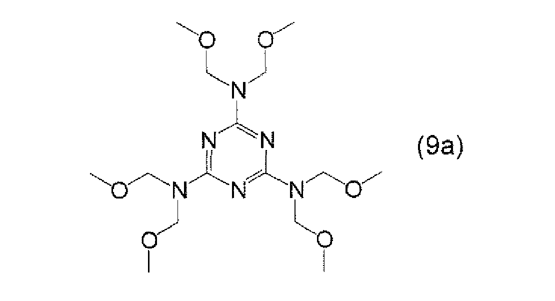

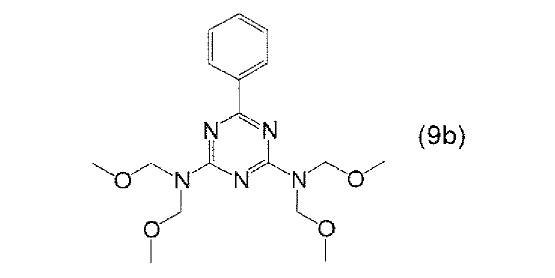

### (Synthesis Example 10)

To 24.80 g of a cation exchange resin (trade name: AMBERLYST 15JWET, manufactured by Rohm and Haas), 3.96 g, 2.96 g, 5.45 g, and 48.71 g, respectively, of monomers of Formula (10), Formula (11), Formula (12), and Formula (13):

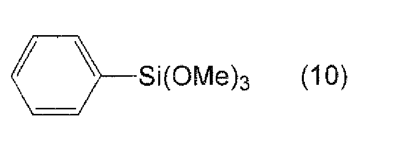

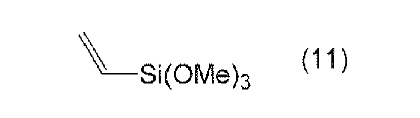

Me-Si(OMe)₃ (12)

Si(OMe)₄ (13)

(all of these are manufactured by Tokyo Chemical Industry Co., Ltd.), 21.61 g of water, and 61.09 g of propylene glycol monomethyl ether were added, and the mixture was stirred at room temperature for 48 hours.

Subsequently, the ion exchange resin was removed by filtration. The filtrate was added dropwise to 143.79 g of propylene glycol monomethyl ether acetate that was heated to 80°C, the mixture was stirred for 4 hours, and then propylene glycol monomethyl ether, a byproduct methanol, and water were distilled off under reduced pressure. The average molecular weights measured by GPC of the reaction product obtained (a polymer or an oligomer) were 1,500 as the weight average molecular weight and 1,100 as the number average molecular weight in terms of standard polystyrene. In the polymer or the oligomer obtained in this Synthesis Example, Ph-Si (phenylsilyl) derived from Formula (10) above is estimated to be a fluorescent moiety.

### <Example 1>

To 1.00 g of the polymer obtained in Synthesis Example 2, 2.16 g of propylene glycol monomethyl ether acetate and 1.08 g of N,N-dimethylformamide were added as solvents. A quartz substrate was coated with the solution using a spinner, and then baked on a hot plate at 205°C for 1 minute. Fluorescence of the coating obtained by baking was measured using Fluorescence Spectrophotometer F-7000 (manufactured by Hitachi High-Technologies Corporation), and the excitation wavelength was 365 nm and the fluorescence wavelength was 450 nm.

### <Example 2>

To 1.00 g of the polymer obtained in Synthesis Example 3, 2.16 g of propylene glycol monomethyl ether acetate and 1.08 g of N,N-dimethylformamide were added as solvents. A quartz substrate was coated with the solution using a spinner, and then baked on a hot plate at 205°C for 1 minute. Fluorescence of the coating obtained by baking was measured using Fluorescence Spectrophotometer F-7000 (manufactured by Hitachi High-Technologies Corporation), and the excitation wavelength was 276 nm and the fluorescence wavelength was 370 nm.

### <Example 3>

To 1.00 g of the polymer obtained in Synthesis Example 4, 2.16 g of propylene glycol monomethyl ether acetate and 1.08 g of N,N-dimethylformamide were added as solvents. A quartz substrate was coated with the solution using a spinner, and then baked on a hot plate at 205°C for 1 minute. Fluorescence of the coating obtained by baking was measured using Fluorescence Spectrophotometer F-7000 (manufactured by Hitachi High-Technologies Corporation), and the excitation wavelength was 322 nm and the fluorescence wavelength was 388 nm.

### <Example 4>

To 1.00 g of the polymer obtained in Synthesis Example 5, 2.16 g of propylene glycol monomethyl ether acetate and 1.08 g of N,N-dimethylformamide were added as solvents. A quartz substrate was coated with the solution using a spinner, and then baked on a hot plate at 205°C for 1 minute. Fluorescence of the coating obtained by baking was measured using Fluorescence Spectrophotometer F-7000 (manufactured by Hitachi High-Technologies Corporation), and the excitation wavelength was 565 nm and the fluorescence wavelength was 587 nm.

### <Example 5>

To 1.00 g of the polymer obtained in Synthesis Example 6, 2.16 g of propylene glycol monomethyl ether acetate and 1.08 g of N,N-dimethylformamide were added as solvents. A quartz substrate was coated with the solution using a spinner, and then baked on a hot plate at 205°C for 1 minute. Fluorescence of the coating obtained by baking was measured using Fluorescence Spectrophotometer F-7000 (manufactured by Hitachi High-Technologies Corporation), and the excitation wavelength was 360 nm and the fluorescence wavelength was 526 nm.

### <Example 6>

To 5.00 g of a solution containing the polymer described in Synthesis Example 7, 5.00 g of propylene glycol monomethyl ether acetate was added as a solvent. A quartz substrate was coated with the solution using a spinner, and then baked on a hot plate at 205°C for 1 minute. Fluorescence of the coating was measured using Fluorescence Spectrophotometer F-7000 (manufactured by Hitachi High-Technologies Corporation), and the excitation wavelength was 366 nm and the fluorescence wavelength was 465 nm.

### <Example 7>

To 5.00 g of a solution containing the polymer described in Synthesis Example 8, 5.00 g of propylene glycol monomethyl ether acetate was added as a solvent. A quartz substrate was coated with the solution using a spinner, and then baked on a hot plate at 205°C for 1 minute. Fluorescence of the coating was measured using Fluorescence Spectrophotometer F-7000 (manufactured by Hitachi High-Technologies Corporation), and the excitation wavelength was 325 nm and the fluorescence wavelength was 460 nm.

### <Example 8>

To 5.00 g of a solution containing the polymer described in Synthesis Example 9, 5.00 g of propylene glycol monomethyl ether acetate was added as a solvent. A quartz substrate was coated with the solution using a spinner, and then baked on a hot plate at 205°C for 1 minute. Fluorescence of the coating was measured using Fluorescence Spectrophotometer F-7000 (manufactured by Hitachi High-Technologies Corporation), and the excitation wavelength was 260 nm and the fluorescence wavelength was 390 nm.

### <Example 9>

To 5.00 g of a solution containing the polymer or the oligomer obtained in Synthesis Example 10, 5.00 g of propylene glycol monomethyl ether acetate was added as a solvent. A quartz substrate was coated with the solution using a spinner, and then baked on a hot plate at 205°C for 1 minute. Fluorescence of the coating was measured using Fluorescence Spectrophotometer F-7000 (manufactured by Hitachi High-Technologies Corporation), and the excitation wavelength was 263 nm and the fluorescence wavelength was 296 nm.

All the coatings formed in the Examples above have a wavelength conversion function, and therefore are useful as a wavelength conversion film to be installed in a photovoltaic device (a solar cell). Furthermore, a solar cell including the wavelength conversion film is expected to be improved in photoelectric conversion efficiency. For example, the coatings formed in Example 1, 3, 6, 7, and 8 can convert a wavelength in ultraviolet range to a wavelength in visible light range, and therefore are useful in a solar cell that is less sensitive to light of a wavelength in ultraviolet range and highly sensitive to light of a wavelength in visible light range.

### <Comparative Example 1>

To 3.00 g of the polymer obtained in Synthesis Example 1, 0.46 g of the monomer of Formula (2): 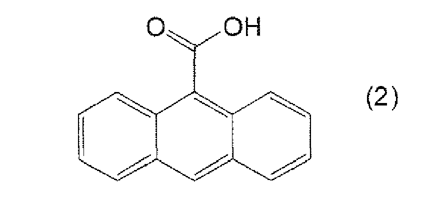 (manufactured by Tokyo Chemical Industry Co., Ltd.) that was used in Synthesis Example 2 and 15.00 g of propylene glycol monoethyl ether acetate as a solvent were added. A quartz substrate was coated with the solution using a spinner, and then baked on a hot plate at 205°C for 1 minute. On the coated side, a contaminant that was considered to originate from the monomer of Formula (2) was observed.

### [Application example of wavelength conversion film]

An example in which the wavelength conversion film according to the present invention is installed in a silicon solar cell is shown in FIG. 1. FIG. 1A shows a cross-sectional structure of a solar cell in which a p-layer 102, an n-layer 103, and an anti-reflective film 104 are laminated on a back electrode 101, a surface electrode 105 is formed to be connected to the n-layer 103, and a covering material 106 is further provided. Usually, a sealing material (not shown) is further provided between the surface electrode 105 or the anti-reflective film 104 and the covering material 106, and a sealing material and a back sheet (not shown) are further provided on the outside of the back electrode 101. On the outside of the back sheet, a total-reflection layer may be provided. The surface electrode 105 is also represented as a light-receiving surface electrode. The covering material 106 is made of glass or resin and, in the former case, it is called a cover glass. In this example, a wavelength conversion film 100 is provided between the n-layer 103 and the anti-reflective film 104.

FIG. 1B shows an example in which, in contrast to the example in FIG. 1A, the wavelength conversion film 100 is provided between the anti-reflective film 104 and the covering material 106. When the wavelength conversion film 100 has a function as a covering material as well, the covering material 106 may be omitted (see FIG. 1C). In the example of FIG. 1B, the covering material 106 having the wavelength conversion film 100 may be a detachable structure. Similarly, in the example of FIG. 1C, the wavelength conversion film 100 having a function as a covering material may be a detachable structure.

FIG. 1D shows an example in which, in contrast to the examples in FIGS. 1A to 1C, the wavelength conversion film 100 is provided on the covering material 106. The covering material 106 having the wavelength conversion film 100 may be a detachable structure.

### Description of the Reference Numerals

- 100: Wavelength conversion film
- 101: Back electrode
- 102: p-layer
- 103: n-layer
- 104: Anti-reflective film
- 105: Surface electrode
- 106: Covering material

## Claims

1. A composition for forming a wavelength conversion film for a photovoltaic device, comprising:
a polymer or an oligomer including a fluorescent moiety; and
a solvent.

2. The composition for forming a wavelength conversion film for a photovoltaic device according to claim 1, wherein the fluorescent moiety is incorporated in a main chain or a side chain of the polymer or the oligomer.

3. The composition for forming a wavelength conversion film for a photovoltaic device according to claim 1 or 2, wherein the fluorescent moiety is anthracene or a derivative thereof, coumarin or a derivative thereof, fluorescein or a derivative thereof, rhodamine, eosin, perylene or a derivative thereof, fluorene or a derivative thereof, or stilbene or a derivative thereof.

4. The composition for forming a wavelength conversion film for a photovoltaic device according to any one of claims 1 to 3, wherein the polymer or the oligomer is an acrylic resin, a methacrylate resin, a novolac resin, an aminoplast polymer, a polyamide, a polyimide, a polyester, polyfluorene, a polyfluorene derivative, a polysiloxane, polysilane, or a polycarbosilane.

5. The composition for forming a wavelength conversion film for a photovoltaic device according to any one of claims 1 to 4, wherein the solvent is at least one organic solvent selected from a group consisting of propylene glycol monomethyl ether acetate, propylene glycol monomethyl ether, ethyl lactate, cyclohexanone, γ-butyrolactone, diethylene glycol monobutyl ether acetate, diethylene glycol monobutyl ether, diethylene glycol dibutyl ether, acetylacetone, toluene, and N,N-dimethylformamide.

6. The composition for forming a wavelength conversion film for a photovoltaic device according to any one of claims 1 to 5, wherein the polymer or the oligomer further includes a crosslinked moiety.

7. The composition for forming a wavelength conversion film for a photovoltaic device according to any one of claims 1 to 6, further comprising a crosslinking agent.

8. The composition for forming a wavelength conversion film for a photovoltaic device according to any one of claims 1 to 7, further comprising an antioxidant and/or a radical scavenger.

9. A wavelength conversion film for a photovoltaic device that is formed from the composition for forming a wavelength conversion film as claimed in any one of claims 1 to 8.

10. The wavelength conversion film for a photovoltaic device according to claim 9, wherein the wavelength conversion film for a photovoltaic device is used to convert a wavelength in ultraviolet range to a wavelength in visible light range.

11. A solar cell comprising the wavelength conversion film for a photovoltaic device as claimed in claim 9 or 10.
